Europäisches Patentamt

European Patent Office

Office européen des brevets

(19)

(11) Veröffentlichungsnummer: **0 289 885**

A1

(12) **EUROPÄISCHE PATENTANMELDUNG**

(21) Anmeldenummer: 88106521.3

(22) Anmeldetag: 22.04.88

(51) Int. Cl.⁴ **H01J 37/09**

(30) Priorität: 08.05.87 DE 3715427

(43) Veröffentlichungstag der Anmeldung:
09.11.88 Patentblatt 88/45

(84) Benannte Vertragsstaaten:
DE FR GB NL

(71) Anmelder: **Siemens Aktiengesellschaft Berlin
und München**
**Wittelsbacherplatz 2**
**D-8000 München 2(DE)**

(72) Erfinder: **Lischke, Burkhard, Prof. Dr.**
**In der Heuluss 13**
**D-8000 München 82(DE)**

(54) **Blendensystem zur Erzeugung mehrerer Teilchensonden mit veränderbarem Querschnitt.**

㊗ In modernen Lithografiegeräten mit Lochblenden
zur Erzeugung vieler Einzelsonden (Kammsonde)
können nur Strukturen hergestellt werden, deren Abmessungen einem ganzzahligen Vielfachen der Abmessungen der Einzelsonden entsprechen. Zur Erzeugung beliebiger Strukturen sollte der Querschnitt
dieser Einzelsonden in seiner Form und Größe einstellbar sein. Es wird deshalb vorgeschlagen, zwei
mit der gleichen Mehrlochstruktur versehene Blenden (SB, FB) im Strahlengang des Lithografiegerätes
derart hintereinander anzuordnen, daß die Ausnehmungen (AS) der ersten Blende (SB) mit den entsprechenden Ausnehmungen (AF) der zweiten Blende
(FB) zusammenfallen. Die mit einem primären Teilchenstrahl (PE) beaufschlagte erste Blende (SB) ist
hierbei mit Ablenkelementen (AX, AY) zur individuellen Verschiebung der Teilchensonden (TS) in der
Ebene der zweiten Blende (FB) ausgestattet. Das
Blendensystem zur gleichzeitigen Änderung des
Querschnitts aller Teilchensonden besteht aus zwei
in Strahlrichtung hintereinander angeordneten und in
einer Ebene senkrecht zur Strahlrichtung verschiebbaren Blenden mit der gleichen Mehrlochstruktur.

**FIG 1**

## Blendensystem zur Erzeugung mehrerer Teilchensonden mit veränderbarem Querschnitt

Die Erfindung betrifft ein Blendensystem zur Erzeugung mehrerer Teilchensonden mit veränderbarem Querschnitt nach den Oberbegriffen der Patentansprüche 1 und 5.

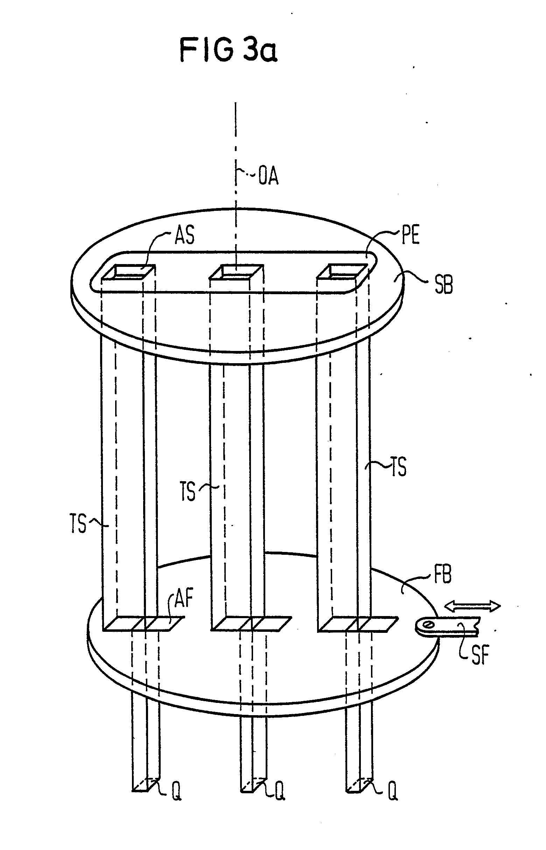

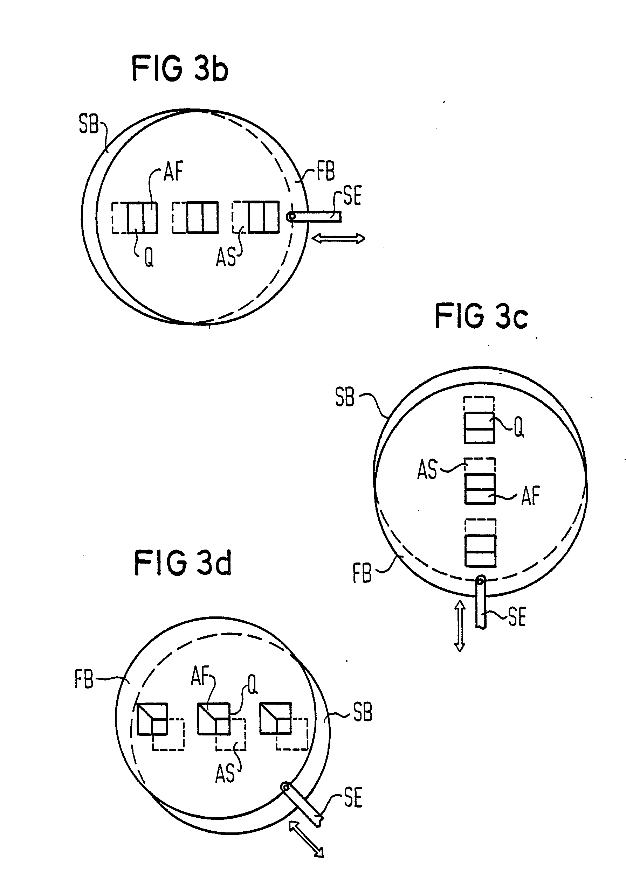

Ein Blendensystem nach dem Oberbegriff des Patentanspruchs 1 ist aus den IEEE Transactions on Electron Devices, Vol. ED-26, Nr. 4, April 1979, Seiten 663 bis 674, insbesondere Figur 3 und 4, bekannt.

Eine Blende mit einer zeilenförmigen Mehrlochstruktur und einem Elektrodensystem zur individuellen Austastung der mit Hilfe der Blende erzeugten Teilchensonden ist aus der DE-OS 35 04 705 bekannt.

In modernen Lithografiegeräten mit Lochblenden zur Erzeugung mehrerer Einzelsonden (Kammsonde) können nur Strukturen hergestellt werden, deren Abmessungen einem ganzzahligen Vielfachen der Abmessungen der Einzelsonden entsprechen. Zur Erzeugung beliebiger Strukturen sollte der Querschnitt der Einzelsonden in seiner Form und Größe einstellbar sein.

Der Erfindung liegt die Aufgabe zugrunde, ein Blendensystem der eingangs genannten Art anzugeben, mit dem eine Vielzahl von Teilchensonden mit veränderbarem Querschnitt erzeugt werden kann. Diese Aufgabe wird erfindungsgemäß durch Blendensysteme nach den Patentansprüchen 1 und 5 gelöst.

Der mit der Erfindung erzielbare Vorteil besteht insbesondere darin, daß der Sondendurchmesser dem gewünschten Design oder Muster bzw. Rastermaß angepaßt werden kann.

Die Ansprüche 2 bis 4, 6 und 7 betreffen bevorzugte Ausgestaltungen und Weiterbildungen der erfindungsgemäßen Blendensysteme.

Die Erfindung wird nachfolgend anhand der Zeichnungen näher erläutert. Dabei zeigt:

FIG 1 ein erstes Ausführungsbeispiel eines erfindungsgemäßen Blendensystems,

FIG 2 das Ablenksystem der von einem primären Teilchenstrahl ausgeleuchteten ersten Blende,

FIG 3 ein zweites Ausführungsbeispiel eines erfindungsgemäßen Blendensystems.

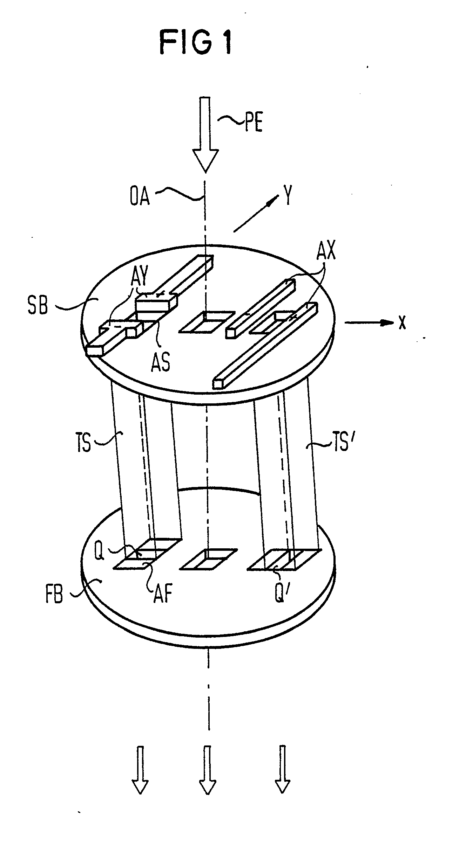

Das in FIG 1 schematisch dargestellte Blendensystem zur Erzeugung mehrerer Teilchensonden mit veränderbarem Querschnitt kann insbesondere in dem aus der DE-OS 35 04 704 bekannten Lithografiegerät (siehe insbesondere FIG 1) verwendet werden, wo es die mit einem großflächigen Elektronenstrahl beaufschlagte Aperturblende ersetzt. Es besteht im wesentlichen aus einer von einem primären Teilchenstrahl PE ausgeleuchteten ersten Blende SB (im folgenden Steuerblende genannt) mit mehreren entlang einer Linie angeordneten rechteckigen oder quadratischen Ausnehmungen AS zur Formung einer entsprechenden Anzahl von Teilchensonden TS und einer in Strahlrichtung OA hinter der Steuerblende SB angeordneten zweiten Blende FB (im folgenden Formblende genannt), die die gleiche Mehrlochstruktur wie die Blende SB aufweist. Die Blenden SB und FB sind hierbei so zueinander orientiert, daß die Ausnehmungen AS der Steuerblende SB mit den entsprechenden Ausnehmungen AF der Formblende FB zusammenfallen (d. h. in Strahlrichtung übereinanderliegen). Zur Änderung des Sondenquerschnitts Q werden die beispielsweise aus einem bandförmigen Primärstrahl PE ausgeblendeten Sonden TS teilchenoptisch auf die Formblende FB abgebildet, oder wie in FIG 1 dargestellt, schattenprojiziert und mit Hilfe der auf der Steuerblende SB im Bereich der Ausnehmungen AS angeordneten Ablenkelemente AX, AY in zwei zueinander orthogonale Richtungen verschoben (aus Gründen der Übersichtlichkeit ist in Fig. 1 jeweils nur ein Ablenkelement AX bzw. AY dargestellt). Der Querschnitt Q, Q' jeder Sonde TS, TS' läßt sich somit durch geeignete Wahl der an den Ablenkelementen AX, AY anliegenden Potentiale auf die gewünschte Größe und Form einstellen.

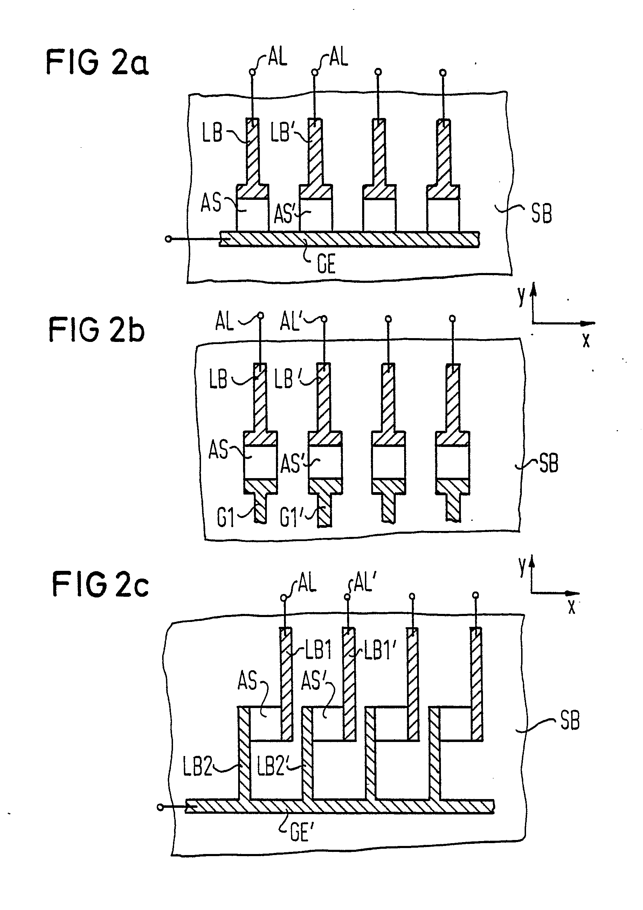

Aus Gründen der Platzersparnis werden die Ablenkelemente AX, AY der Steuerblende SB vorteilhafterweise getrennt für jede Ablenkrichtung auf deren Ober- bzw. Unterseite angeordnet. Eine mögliche Ausführungsform einer solchen Steuerblende SB ist in FIG 2 dargestellt. Sie besteht aus einer hochohmigen Substratfolie, beispielsweise aus Silizium, mit quadratischen Ausnehmungen AS, AS' zur Ausblendung entsprechend geformter Teilchensonden. Die im Randbereich der Ausnehmungen AS, AS' auf der dem Primärstrahl PE zugewandten Oberfläche der Steuerblende SB angeordneten Ablenkelemente (siehe FIG 2a) sind als endseitig verbreiterte Leiterbahnen LB, LB' ausgeführt, die man über die Anschlüsse AL, AL' mit geeigneten Potentialen beaufschlagt (y-Ablenkung). Als gemeinsame Gegenelektrode wirkt eine auf Bezugspotential liegende Leiterbahn GE, die wie die Ablenkelektroden LB, LB' beispielsweise aus Gold besteht. Anstelle dieser Leiterbahn GE kann man selbstverständlich auch Einzelelektroden G1, G1' verwenden, die individuell ansteuerbar sind oder alle auf Bezugspotential liegen (siehe FIG 2b).

Die auf der Unterseite der Steuerblende SB vorgesehenen Ablenkelemente (siehe FIG 2c) zur Verschiebung der Teilchensonden in Richtung der x-Achse bestehen jeweils aus einem am Rand jeder Ausnehmung AS, AS' angeordneten Elektrodenpaar LB1 LB2 bzw. LB1' LB2', wobei die Elektroden LB2 und LB2' mit der auf Bezugspotential liegenden gemeinsamen Elektrode GE' verbunden sind. Die gewünschten Ablenkpotentiale werden wieder über getrennte Anschlüsse AL, AL' in die den Leiterbahnen LB2 und LB2' jeweils gegenüberliegenden Elektroden LB1 und LB1' eingespeist.

Die Elektrodensysteme zur Ablenkung der Teilchensonden in zwei zueinander orthogonale Richtungen können auch auf zwei in Strahlrichtung OA unmittelbar hintereinanderliegenden Steuerblenden mit der gleichen Mehrlochstruktur angeordnet werden. Diese Steuerblenden sind hierbei so zueinander orientiert, daß die Ausnehmungen der ersten Steuerblende SB mit den entsprechenden Ausnehmungen der zweiten Steuerblende in Strahlrichtung OA zusammenfallen.

Ein vergleichsweise sehr viel einfacher aufgebautes Blendensystem, mit dem der Querschnitt aller Teilchensonden TS gleichzeitig geändert und auf das gewünschte Maß reduziert werden kann, ist schematisch in FIG 3 dargestellt. Es besteht erfindungsgemäß aus einer von einem vorzugsweise bandförmigen Teilchenstrahl PE ausgeleuchteten kreisförmigen Steuerblende SB mit mehreren entlang einer Linie angeordneten rechteckigen oder quadratischen Ausnehmungen AS und einer in Strahlrichtung OA hinter der Steuerblende SB angeordneten Formblende FB, die die gleiche Mehrlochstruktur wie die Steuerblende aufweist und beispielsweise mit Hilfe piezoelektrischer Elemente (in FIG 3 durch eine Steuerstange SE angedeutet) in einer Ebene senkrecht zur Strahlrichtung OA verschiebbar ist. Im nicht verschobenen Zustand sind die Blenden SB, FB so zueinander orientiert, daß die Ausnehmungen AS der Steuerblende SB mit den entsprechenden Ausnehmungen AF der Formblende FB zusammenfallen. Durch Änderung des Überdeckungsgrades der Ausnehmungen AS und AF der Steuer-bzw. Formblende SB, FB können Teilchensonden TS mit einer dem jeweils gewünschten Muster angepaßten Querschnittsfläche Q (siehe FIG 3b bis FIG 3d) erzeugt und in konventioneller Weise auf die zu strukturierende Probe abgebildet werden.

Die beschriebenen Blenden können in Planartechnik, beispeilsweise unter Anwendung des aus der DE-OS 35 04 705 (siehe insbesondere die Seiten 11 und 12) bekannten Verfahrens hergestellt werden. Hierdurch ist es möglich. eine sehr große Zahl von Ausnehmungen AS, AF mit den jeweils zugeordneten Ablenkelementen AX, AY auf einer sehr kleinen Fläche zu konzentrieren. So sind beispielsweise 2000 Ausnehmungen mit einer Seitenlänge von jeweils $10 \times 10$ µm denkbar, die eine entsprechende Anzahl von Teilchensonden TS aus dem primären Ionen-oder Elektronenstrahl PE ausblenden. Bildet man diese Teilchen sonden TS um einen Faktor 100 verkleinert auf eine Probe ab, so lassen sich Strukturen mit Abmessungen im Bereich von etwa 20 bis 100 nm erzeugen.

Die Erfindung ist selbstverständlich nicht auf die beschriebenen Ausführungsbeispiele beschränkt. So können die Blenden SB und FB außerhalb der Ausnehmungen AS und AF noch mit einer leitenden Schicht bedeckt sein (Ableitung der auftreffenden Primärteilchen). Es ist auch nicht notwendig die Ausnehmungen AS, AF in einer Reihe anzuordnen. Diese können beispielsweise auch seitlich versetzt zueinander liegen.

Anstelle der beschriebenen Ablenkelemente können auch andere Verschiebemittel zur Einstellung der Größe und Form der Teilchensonden verwendet werden.

In dem Blendensystem nach FIG 3 ist es selbstverständlich auch möglich, die Blende SB anstelle der Blende FB bzw. beide Blenden gemeinsam (in unterschiedlichem Ausmaß oder in verschiedenen Richtungen) in einer Ebene senkrecht zur Strahlrichtung zu verschieben.

## Ansprüche

1. Blendensystem zur Erzeugung mehrerer Teilchensonden (TS) mit veränderbarem Querschnitt (Q) mit einer von einem Teilchenstrahl (PE) beaufschlagten ersten Blende (SB) die eine erste Mehrlochstruktur aufweist, einer in Strahlrichtung (OA) hinter der ersten Blende (SB) angeordneten zweiten Blende (FB) und Mitteln zur Änderung der Lage der Teilchensonden (TS) in der Ebene der zweiten Blende (FB), dadurch **gekennzeichnet,** daß die zweite Blende (FB) eine der ersten Mehrlochstruktur entsprechende zweite Mehrlochstruktur aufweist, wobei die erste und die zweite Blende (SB, FB) so zueinander orientiert sind, daß die Ausnehmungen (AS) der ersten Mehrlochstruktur mit den entsprechenden Ausnehmungen (AF) der zweiten Mehrlochstruktur zusammenfallen.

2. Blendensystem nach Anspruch 1, dadurch **gekennzeichnet,** daß Ablenkelemente (AX, AY) zur individuellen Verschiebung der Teilchensonden (TS) in der Ebene der zweiten Blende (FB) am Rand der Ausnehmungen (AS) der ersten Blende (SB) angeordnet sind.

3. Blendensystem nach Anspruch 1 oder 2. dadurch **gekennzeichnet,** daß erste Ablenkelemente (LB, GE) zur Ablenkung der Teilchensonden (TS) in eine erste Richtung auf der Oberseite der ersten Blende (SB) und zweite Ablenkelemente (LB1, LB2, GE') zur Ablenkung der Teilchensonden (TS) in eine zweite Richtung auf der Unterseite der ersten Blende (SB) angeordnet sind.

4. Blendensystem nach Anspruch 1 oder 2, dadurch **gekennzeichnet,** daß erste Ablenkelemente (AX) zur Ablenkung der Teilchensonde (TS) in eine erste Richtung auf der ersten Blende (SB) angeordnet sind und daß zweite Ablenkelemente (AY) zur Ablenkung der Teilchensonden (TS) in eine zweite Richtung auf einer in Strahlrichtung (OA) unmittelbar hinter der ersten Blende (SB) angeordneten dritten Blende angeordnet sind, wobei die dritte Blende eine der ersten Mehrloch struktur entsprechende dritte Mehrlochstruktur aufweist und so zur ersten Blende (SB) ausgerichtet ist, daß die Ausnehmungen der ersten Blende (SB) mit den entsprechenden Ausnehmungen der dritten Blende zusammenfallen.

5. Blendensystem zur Erzeugung mehrerer Teilchensonden (TS) mit veränderbarem Querschnitt (Q) mit einer von einem Teilchenstrahl (PE) beaufschlagten ersten Blende (SB) die eine erste Mehrlochstruktur aufweist und einer in Strahlrichtung (OA) hinter der ersten Blende (SB) angeordneten zweiten Blende (FB), dadurch **gekennzeichnet,** daß die erste und/oder die zweite Blende (SB, FB) in einer Ebene senkrecht zur Strahlrichtung (OA) verschiebbar ist und daß die zweite Blende (FB) eine der ersten Mehrlochstruktur entsprechende zweite Mehrlochstruktur aufweist, wobei die erste und die zweite Blende (SB, FB) im nichtverschobenen Zustand so zueinander orientiert sind, daß die Ausnehmungen (AS) der ersten Mehrlochstruktur mit den entsprechenden Ausnehmungen (AF) der zweiten Mehrlochstruktur zusammenfallen.

6. Blendensystem nach Anspruch 1 oder 5, dadurch **gekennzeichnet,** daß die Mehrlochstrukturen annähernd rechteckige oder quadratische Ausnehmungen (AS, AF) aufweisen.

7. Blendensystem nach Anspruch 6, dadurch **gekennzeichnet,** daß die Ausnehmung (AS, AF) entlang einer Linie angeordnet sind.

# FIG 1

PE

OA

Y

AX

AY

SB

X

AS

TS

TS'

Q

FB

AF

Q'

# FIG 2a

# FIG 2b

# FIG 2c

# FIG 3a

OA

AS PE

SB

TS TS

TS

FB

AF

SF

Q Q Q

FIG 3b

SB  
AF  
FB  
SE  
Q  
AS

FIG 3c

SB  
Q  
AS  
AF  
FB  
SE

FIG 3d

FB  
AF  
Q  
SB  
AS  
SE

# EUROPÄISCHER RECHERCHENBERICHT

## EINSCHLÄGIGE DOKUMENTE

EP 88106521.8

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE - A1 - 3 504 714 (SIEMENS)<br>* Ansprüche *<br>-- | 1,5 | H 01 J 37/09 |
| A | EP - A2 - 0 043 351 (ZEISS)<br>---- | | |

### RECHERCHIERTE SACHGEBIETE (Int. Cl.4)

H 01 J 37/00

H 01 J  3/00

H 01 J  9/00

Der vorliegende Recherchenbericht wurde für alle Patentansprüche erstellt.

| Recherchenort | Abschlußdatum der Recherche | Prüfer |
|---|---|---|
| WIEN | 08-08-1988 | BRUNNER |